# DEMANDE DE BREVET EUROPEEN

(11) **EP 2 101 164 A1**
(43) Date de publication de la demande: **16.09.2009**
(21) Numéro de dépôt: 09154590.5
(22) Date de dépôt: 09.03.2009
(51) Int. Cl.: G01N 1/28, H01L 21/268

(54) **Procédé de réparation d'un echantillon destiné à être analysé par microscopie électronique**

(30) Priorité: 11.03.2008 FR 0851545
(71) Demandeur: Commissariat à l'Energie Atomique, 75015 Paris (FR)
(72) Inventeur: Cooper, David, 38000, GRENOBLE (FR)
(74) Mandataire: Ilgart, Jean-Christophe

(57) **Abrégé**

Procédé de réparation de défauts cristallins enterrés au sein d'un échantillon (10) provenant d'un dispositif semi-conducteur, cet échantillon (10) ayant été préparé par utilisation d'un faisceau ionique focalisé ayant causé lesdits défauts, caractérisé en ce qu'il consiste à exposer l'échantillon (10) à un recuit laser, le laser (12) ayant une puissance suffisamment basse pour ne pas faire fondre le matériau semi-conducteur de l'échantillon (10) mais étant suffisamment importante pour éliminer les défauts et en ce que la densité de puissance du laser (12) est comprise entre environ 235 et 290 mJ/cm² pour une épaisseur d'échantillon supérieure à environ 300 nm.

## Description

### DOMAINE TECHNIQUE

La présente invention concerne la préparation d'échantillons devant être analysés par microscopie électronique en particulier en transmission (TEM) et plus particulièrement encore par holographie électronique. La technique d'holographie électronique, originalement imaginée par Denis Gabor, est basée sur la formation d'une image d'interférence, ou hologramme. Cette technique d'holographie électronique et notamment la technique d'holographie électronique hors-axe permet de retrouver la phase électronique perdue dans les autres techniques d'imagerie. Grâce à cette technique d'holographie électronique hors-axe, on peut mesurer les champs magnétiques et électriques locaux, à l'intérieur et à l'extérieur d'un échantillon à l'échelle nanométrique. Pour la nanoélectronique, c'est un outil de caractérisation incomparable. Son principe est le suivant : une source cohérente d'électrons est divisée en deux faisceaux électroniques. L'un d'eux traverse l'échantillon à analyser et le second, se propageant dans le vide, sert de référence. Les deux faisceaux arrivent sur un biprisme de telle sorte qu'ils interfèrent, puisque les faisceaux sont cohérents. Un hologramme électronique se forme en sortie du biprisme. A partir de l'hologramme électronique, il est possible d'obtenir d'une part des informations de phase et d'autre part des informations d'amplitude de l'onde électronique ayant donné l'hologramme. Ces informations sont d'habitude mélangées dans une image électronique conventionnelle et elles ne peuvent être récupérées séparément. Si l'échantillon à analyser n'est pas magnétique, la phase d'un électron est proportionnelle au champ électrostatique dans l'échantillon. Si ce dernier est en matériau semi-conducteur dopé, on peut acquérir une carte des dopants dans l'échantillon avec une résolution à l'échelle nanométrique.

La difficulté liée à cette technique d'holographie électronique est de préparer l'échantillon à analyser. Il faut disposer d'un échantillon très mince, de l'ordre de quelques centaines de nanomètres, le plus transparent possible aux électrons au moins dans la région d'intérêt.

### ÉTAT DE LA TECHNIQUE ANTÉRIEURE

Actuellement les échantillons sont préparés par usinage par faisceau d'ions focalisé (FIB milling en anglais). On peut obtenir un échantillon à faces sensiblement parallèles avec une spécificité de site appropriée. Un faisceau d'ions gallium est utilisé pour découper l'échantillon dans un dispositif semi-conducteur tel un transistor par exemple. L'échantillon peut ensuite être désépaissi, si le faisceau d'ions balaye la surface de l'échantillon jusqu'à ce que l'épaisseur requise, de l'ordre de 400 nanomètres soit atteinte. Mais l'inconvénient est que le faisceau d'ions gallium conduit à des dommages importants sur l'échantillon. Une couche surfacique amorphe avec une concentration importante d'ions gallium implantés et des défauts cristallins enterrés en profondeur dans des régions cristallines de l'échantillon se forment. Les défauts dans les régions cristallines de l'échantillon ont pour effet de piéger des dopants. Cela a pour conséquence une modification dans la phase de la carte des dopants obtenue par l'analyse qui est inférieure à celle prédite par la théorie. La modification cristalline engendre des défauts électriques.

Il faut donc traiter l'échantillon pour que lors de son analyse par holographie électronique, il puisse être observé sans être altéré par les défauts engendrés par l'usinage par faisceau d'ions focalisé.

Dans le document [1] dont les références se trouvent en fin de description, il est préconisé pour augmenter significativement le signal de phase mesuré dans les images holographiques de jonctions pn d'un échantillon obtenu par usinage par faisceau d'ions focalisé, de faire subir à l'échantillon, un traitement de recuit thermique in situ pendant l'analyse par holographie électronique pour réparer les défauts. Le traitement consiste à réaliser des paliers à des températures de plus en plus importantes pendant une durée d'une heure par palier, chaque palier étant suivi d'un repos à température ambiante pendant une demi-heure. On réactive les dopants dans la structure cristalline. On mesure l'inverse de la phase due à une réduction dans la couche inactive électriquement. On augmente le signal sur bruit dans l'image de phase.

Malheureusement on s'aperçoit qu'avec un tel traitement les dopants se trouvant normalement dans l'objet dans lequel a été prélevé l'échantillon diffusent et que la carte des dopants obtenue par l'holographie électronique est faussée et n'est pas représentative de l'objet dans lequel a été prélevé l'échantillon.

Dans le document [2] il est enseigné d'utiliser un recuit laser pour éliminer des défauts dans des dispositifs semi-conducteurs dans lesquels des ions ont été implantés et ce au cours de leur fabrication. Ce document ne décrit pas le traitement d'échantillons prélevés dans le dispositif.

Dans le document [3] il est préconisé de soumettre un échantillon en silicium dopé avec des ions de bore à un recuit laser excimère (longueur d'onde 308 nm avec des impulsions de 28 ns) ce qui permet d'activer électriquement les ions de bore. Au-delà d'une densité énergétique du laser de 450 mJ/cm² le silicium fond et l'activation se produit.

Dans le document [4], il est préconisé d'utiliser un laser excimère de manière à poursuivre l'amincissement de l'échantillon après un amincissement par faisceau d'ions focalisé et à obtenir un fini plus satisfaisant. Les caractéristiques des impulsions laser sont telles qu'elles coupent les liaisons atomiques à la surface ou à proximité de la surface de l'échantillon.

Aucun des deux derniers documents ne propose de faire une réparation mais seulement soit une activation des dopants, soit l'obtention d'un meilleur fini en surface.

Dans le document [5], il est préconisé pour éliminer les ions implantés lors de l'usinage ionique, de faire subir à l'échantillon un recuit laser visant, grâce à la fusion, à faire remonter en surface les ions implantés, ces derniers étant éliminés, après refroidissement grâce à un agent chélatant. Les défauts dans la structure cristalline ne sont pas pour autant réparés même si les ions piégés sont éliminés. Ce document a pour but d'enlever les ions implantés, ils ne restent pas dans l'échantillon.

### EXPOSÉ DE L'INVENTION

La présente invention a justement comme but de proposer un procédé visant à réellement réparer des défauts cristallins contenus dans un échantillon provenant d'un dispositif semi-conducteur, causés par un faisceau ionique focalisé ayant servi à le préparer, sans engendrer de diffusion d'ions implantés dans l'échantillon et notamment d'ions se trouvant normalement dans le dispositif semi-conducteur dans lequel l'échantillon a été prélevé.

Pour atteindre ces buts l'invention concerne plus précisément un procédé de réparation de défauts cristallins enterrés au sein d'un échantillon provenant d'un dispositif semi-conducteur, cet échantillon ayant été préparé par utilisation d'un faisceau ionique focalisé ayant causé lesdits défauts, dans lequel on soumet l'échantillon à un recuit laser, le laser ayant une puissance suffisamment basse pour ne pas faire fondre le matériau semi-conducteur de l'échantillon, mais suffisamment importante pour éliminer les défauts.

La densité de puissance du laser est comprise entre environ 235 et 290 mJ/cm² pour une épaisseur d'échantillon supérieure à environ 300 nm et plus particulièrement supérieure à environ 400 nanomètres.

On choisira un laser ultra-violet, par exemple un laser excimère et le laser excimère pourra émettre des impulsions avec une fréquence de répétition de 10 Hz et une durée d'environ 20 ns.

On donnera de préférence au faisceau du laser un diamètre d'environ 700 micromètres.

Le laser sera animé d'un mouvement de balayage avec un pas d'environ 350 micromètres.

De plus, on s'arrange pour que le laser irradie trois fois une zone de l'échantillon pendant le balayage.

### BRÈVE DESCRIPTION DES DESSINS

La présente invention sera mieux comprise à la lecture de la description d'un exemple de réalisation donné, à titre purement indicatif et nullement limitatif, en faisant référence aux dessins annexés sur lesquels :
La figure 1 une vue d'un échantillon d'un dispositif semi-conducteur obtenu par usinage par faisceau d'ions focalisé et pourvu de défauts cristallins enterrés que l'on cherche à éliminer ;
La figure 2 une installation permettant de mettre en oeuvre le procédé de l'invention.

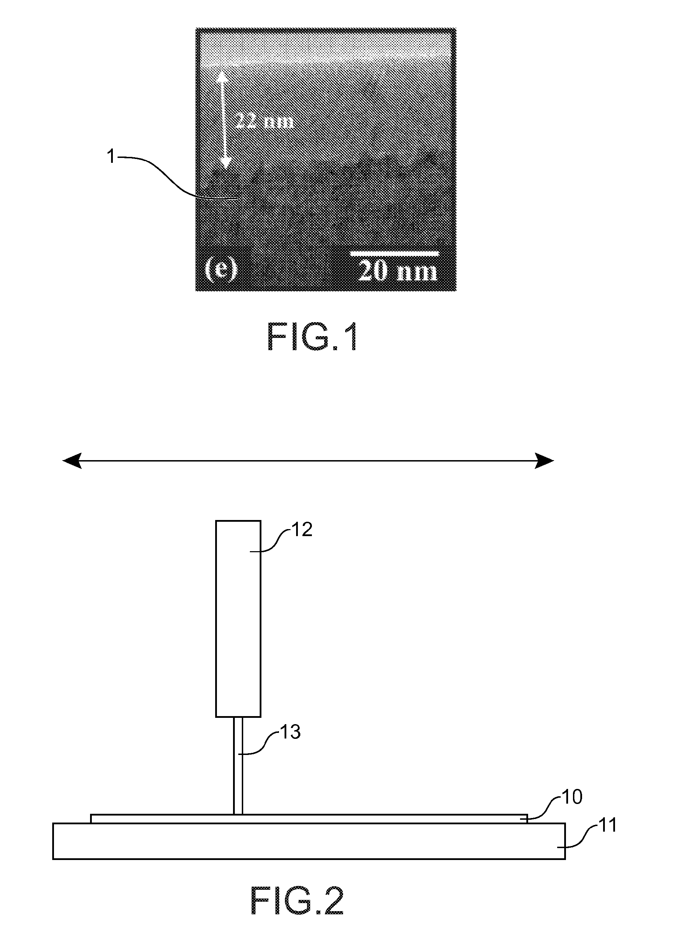

Les différentes parties représentées sur la figure 2 ne le sont pas nécessairement selon une échelle uniforme, pour rendre la figure plus lisible.

### EXPOSÉ DÉTAILLÉ DE MODES DE RÉALISATION PARTICULIERS

On se réfère à la figure 1 qui est une image d'un échantillon prélevé dans un dispositif semi-conducteur par usinage par faisceau d'ions focalisé. Les ions utilisés peuvent être des ions Ga⁺, des ions Si⁺, des ions O⁺, des ions Ar⁺. Si les ions implantés sont des ions Si⁺ et que l'échantillon est en silicium, les ions implantés disparaissent dans l'échantillon, il n'y a pas d'impuretés qui subsistent.

Cette image est obtenue à l'aide d'un microscope électronique fonctionnant en transmission. Si le microscope permet de faire de l'holographie électronique, on peut dresser une carte des zones dopées de l'échantillon. C'est à ce type d'échantillon que s'applique le procédé de réparation de l'invention. On distingue en surface une couche amorphe dont l'épaisseur vaut environ 22 nanomètres et sous-jacent à la couche amorphe du matériau semi-conducteur cristallin contenant des défauts cristallins 1 que l'on veut éliminer par la réparation. Ces défauts 1 correspondent aux zones sombres disséminées dans la zone cristalline. Ces défauts 1 proviennent de l'interaction entre les ions implantés et les atomes du matériau semi-conducteur cristallin de l'échantillon lors de l'usinage par faisceau d'ions focalisé. Les défauts sont dans la zone cristalline et pas dans la zone amorphe. La couche amorphe superficielle n'est pas éliminée avec le procédé de réparation de l'invention. Cela n'est pas un problème car il est possible d'en limiter l'épaisseur en abaissant la tension d'accélération des ions lors du prélèvement de l'échantillon.

Sur la figure 2, on a représenté un échantillon 10 d'un dispositif semi-conducteur en train d'être réparé selon le procédé de l'invention. L'échantillon 10 est une partie prélevée dans un dispositif semi-conducteur, à base de silicium par exemple. D'autres matériaux semi-conducteurs sont utilisables tels que le gallium, le silicium-germanium, l'arséniure de gallium, le phosphure d'indium, le nitrure de gallium, le SOI (silicium sur isolant). Le dispositif semi-conducteur peut être un transistor et comporter normalement une ou plusieurs zones dopées correspondant à des jonctions pn. Ces zones dopées se trouvant dans le dispositif semi-conducteur avant le prélèvement de l'échantillon 10 ne constituent pas les défauts que l'on veut réparer.

Les défauts de l'on veut réparer sont introduits lors de la préparation de l'échantillon 10 et notamment lors du prélèvement de l'échantillon 10 par usinage par faisceau d'ions focalisé. Mais les défauts que l'on veut réparer sont localisés dans les zones dopées.

Les dopants que l'on veut conserver, sans qu'ils diffusent, sont de nature autre que le dopant introduit lors de l'usinage ionique.

L'échantillon 10 à réparer repose sur une table 11, par exemple en verre. On utilise un laser 12 pour soumettre l'échantillon 10 à un recuit laser. Le laser 12 est animé d'un mouvement de balayage au dessus d'une surface principale de l'échantillon 10.

Le laser va transférer de l'énergie à l'échantillon, cette énergie va réparer la région dans laquelle se trouvent les défauts cristallins. Le transfert d'énergie doit être suffisamment rapide de manière à ce que la réparation se fasse sans qu'une diffusion des dopants n'intervienne. La durée des impulsions du laser conditionne l'énergie transférée à l'échantillon. Par exemple on peut utiliser un laser XeCl ayant des impulsions de 20 nanosecondes et une densité de puissance de 290 mJ/cm².

Tout type de laser peut être employé dans l'invention y compris un laser à rubis, mais l'homme du métier adaptera la puissance et la durée de l'impulsion à l'échantillon à traiter. Par exemple, le laser 12 pourra être un laser ultra-violet tel un laser excimère. Les lasers excimère sont des lasers à gaz, pulsés, émettant un rayonnement ultra-violet. Ils émettent un faisceau 13 présentant une répartition d'énergie sensiblement uniforme. Des mesures effectuées ont été faites à l'aide d'un laser excimère XeCl 12 émettant à 308 nanomètres. La fréquence de répétition des impulsions est de 10 Hz et la durée des impulsions est de l'ordre de 20 nanosecondes. Une telle durée d'impulsions permet d'éviter la diffusion des dopants se trouvant dans l'échantillon 10. Ces paramètres correspondent aux réglages par défaut du laser 12.

Le laser 12 a un faisceau 13 dont le diamètre est d'environ 700 micromètres. Le balayage employé possède un pas de l'ordre de 350 micromètres. Le balayage employé a été tel que chaque zone traitée de l'échantillon 10 par le recuit a été exposé au moins une fois et avantageusement trois fois au faisceau 13 laser 12 durant le balayage.

Les échantillons 10 qui ont été soumis à ce recuit par laser avaient des épaisseurs comprises entre environ 200 et 500 nanomètres.

Plusieurs expériences ont été menées dans plusieurs plages de densité de puissance. La réparation a été très satisfaisante avec des densités de puissance comprises entre environ 235 et 290 mJ/cm² pour une épaisseur d'échantillon comprise entre environ 300 et 500 nanomètres car les défauts liés au piégeage de dopants provenant de l'étape d'usinage ionique ont disparu. Les défauts sont éliminés lors du transfert d'énergie issue du laser à l'échantillon. Les atomes du matériau semi-conducteur cristallin et les ions du dopant sont remis en place dans le réseau cristallin.

Les ions sont situés à proximité de la couche amorphe à une profondeur inférieure à environ 30 nanomètres ou dans la couche amorphe. Si on utilise des ions de même matériau que le matériau semi-conducteur, il n'y a pas d'impuretés.

Des densités de puissances supérieures, jusqu'à environ 880 mJ/cm2 conduisent à une fusion du matériau semi-conducteur, ce qui rend la caractérisation par microscopie électronique impossible et des densités de puissance plus faibles conduisent à une réparation trop incomplète.

L'holographie électronique pour l'analyse d'échantillons semi-conducteurs est utilisée de puis plus de vingt ans, il en est de même pour l'usinage par faisceau d'ions focalisé pour la préparation des échantillons, mais à ce jour aucune méthode de réparation des échantillons satisfaisante n'a été proposée.

### DOCUMENTS CITES

[1] "Improvement in electron holographic phase images of focussed-ion-beam-milled GaAs and Si p-n junctions by in situ annealing" David Cooper et al., Applied Physics Letters, vol. 88 063510 (2006).
[2] "Transient annealing of semiconductors by laser, electron beam and radiant heating techniques", A G Cullis 1985 Rep. Prog. Phys., Vol. 48, pages 1155-1233.
[3] "Dopant redistribution and electrical activation in silicon following ultra-low energy boron implantation and excimer laser annealing" S. Whelan et al., Physical Review B 67, 075201 (2003).
[4] "Laser assisted sample finish" H. Ichinose et al. IMC16, Sapporo, 2006.
[5] JP -A- 2005-172765.

## Revendications

1. Procédé de réparation de défauts cristallins enterrés au sein d'un échantillon (10) provenant d'un dispositif semi-conducteur, cet échantillon (10) ayant été préparé par utilisation d'un faisceau ionique focalisé ayant causé lesdits défauts, **caractérisé en ce qu'**il consiste à exposer l'échantillon (10) à un recuit laser, le laser (12) ayant une puissance suffisamment basse pour ne pas faire fondre le matériau semi-conducteur de l'échantillon (10) mais étant suffisamment importante pour éliminer les défauts et **en ce que** la densité de puissance du laser (12) est comprise entre environ 235 et 290 mJ/cm² pour une épaisseur d'échantillon supérieure à environ 300 nm.

2. Procédé selon la revendication 1, dans lequel le laser (12) est un laser ultra violet tel un laser excimère.

3. Procédé selon l'une des revendications 1 ou 2, dans lequel le laser (12) émet des impulsions avec une fréquence de répétition de 10 Hz et une durée d'environ 20 ns.

4. Procédé selon l'une des revendications précédentes dans lequel le laser (12) possède un faisceau (13) ayant un diamètre d'environ 700 micromètres.

5. Procédé selon la revendication 4, dans lequel le laser (12) est animé d'un mouvement de balayage avec un pas d'environ 350 micromètres.

6. Procédé selon la revendication 5, dans lequel le laser (12) irradie une zone de l'échantillon trois fois pendant le balayage.
